# EUROPEAN PATENT SPECIFICATION

(11) **EP 1 729 322 B1**
(45) Date of publication and mention of the grant of the patent: **11.01.2012**
(21) Application number: 06252784.1
(22) Date of filing: 30.05.2006
(51) Int. Cl.: H01J 37/32, H01B 7/30

(54) **Plasma processing device**
Plasmaverarbeitungseinrichtung
Dispositif de traitement au plasma

(30) Priority: 31.05.2005 US 685853 P
(43) Date of publication of application: 06.12.2006
(73) Proprietor: NGK Insulators, Ltd., Nagoya-City, Aichi Pref. 467-8530 (JP)
(72) Inventor: Tomita, Yasumitsu, NGK Insulators, Ltd., Nagoya City Aichi-ken 467-8530 (JP); Unno, Yutaka, NGK Insulators, Ltd., Nagoya City Aichi-ken 467-8530 (JP)
(74) Representative: Paget, Hugh Charles Edward

(56) References cited:
- DE-A1- 10 008 484
- US-A1- 2003 169 553
- US-A1- 2005 001 490

## Description

### CROSS REFERRENCE TO RELATED APPLICATION

This application is based upon and claims the benefit of priority from prior U.S. Provisional Application No. 60/685,853, filed on May 31, 2005.

### BACKGROUND OF THE INVENTION

### 1. Field of the Invention

The present invention relates to a plasma processing device.

### 2. Description of the Related Art

In conventional semiconductor or liquid crystal manufacturing processes, a plasma processing device is used. The plasma processing device includes a power supply member supplying high frequency current to a RF electrode (high frequency electrode), for example, a Ni rod which is a metal conductor (for example, see the Japanese Patent Laid-open publication No. 11-26192).

When high frequency voltage is applied to the power supply member, because of the skin effect, current is concentrated in surface part of the power supply member (for example, a range from the surface of the power supply member to a depth of several to several tens micrometers thereof), and very little current flows through radial center part of the power supply member.

Resistance of the power supply member is expressed by the following equation (1). However, as described above, since very little current flows through the radial center part of the power supply member because of the skin effect, apparent cross-sectional area S is reduced, and resistance R is increased.

### (1) R = L/σS (R: resistance, L: length of the power supply member, σ: conductivity, S: cross-sectional area)

On the other hand, an amount of heat generated by the power supply member is expressed by the following equation (2). As the resistance R is increased, the amount of heat generated is increased.

### (2) W = RI² (W: amount of heat generated, R: resistance, I: current)

As described above, with the power supply member in the conventional plasma processing device, the amount of heat generated by the power supply member was increased by the increase in resistance due to the skin effect, which could accelerate degradation of the power supply member itself. Moreover, the heat generation by the power supply member could damage peripheral members disposed in the vicinity of the power supply member. Furthermore, an increase in resistance of the power supply member due to the degradation of the power supply member could increase impedance of the plasma processing device and prevent plasma from being normally generated.

US 2003/0169553 discloses a high temperature cable including a wire bundle having a plurality of copper strands wherein each strand has a barrier coating and an anti-oxidising coating.

### SUMMARY OF THE INVENTION

An object of the present invention is to provide a plasma processing device in which an amount of heat generated from a power supply member is reduced when high frequency current is applied to the power supply member.

In order to achieve the above object, a plasma processing device according to the present invention is defined in claim 1.

With the plasma processing device according to the present invention, the power supply member includes the high conductivity metal layer. Accordingly, when high frequency voltage is applied to the power supply member, part of current flowing through surface part of the power supply body flows through the high conductivity metal layer. This can reduce the resistance of the surface part of the power supply member when the high frequency voltage is applied to the power supply member, thus considerably reducing the amount of heat generated from the power supply member.

### BRIEF DESCRIPTION OF THE DRAWINGS

FIG. 1 is a perspective view of a first power supply member according to a first embodiment of the present invention.
FIG. 2 is a perspective view showing the power supply member of FIG. 1 with upper part of a high conductivity metal layer omitted.
FIG. 3 is a perspective view of a second power supply member for use in the plasma processing device of the present invention.
FIG. 4 is a perspective view showing the power supply member of FIG. 3 with upper part of a high conductivity metal layer and an diffusion preventing metal layer omitted.
FIG. 5̊; is a perspective view showing a substrate heater which is a plasma processing device.

### DETAILED DESCRIPTION

Hereinafter, a description is given of two power supply members and the plasma processing device of the present invention.

First, the description is given of a power supply member with a high conductivity metal layer formed in an outer peripheral surface (on the surface side) of a power supply body.

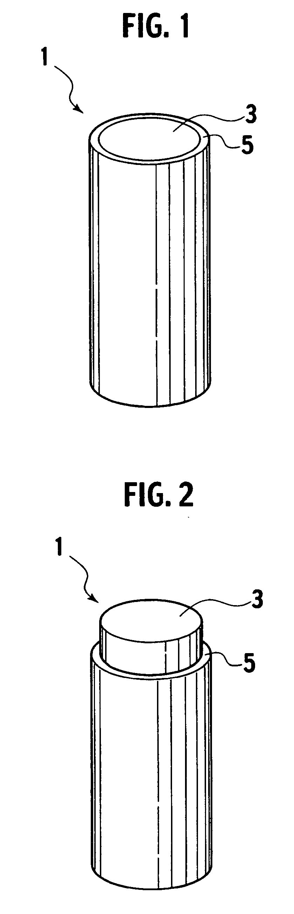

FIG. 1 is a perspective view of this power supply member, and FIG. 2 is a perspective view showing the power supply member of FIG. 1 with upper part of a high conductivity metal layer omitted.

As shown in FIGS. 1 and 2, the power supply member 1 is formed into a rod (an elongated solid cylinder) extending in the vertical direction in the drawings. The power supply member 1 includes an operation of supplying high frequency current to a high frequency electrode which generates plasma.

The power supply member 1 includes a power supply body 3, which is formed into an elongated rod, and a high conductivity metal layer 5, which is shaped in a substantially hollow cylinder and formed on the outer peripheral surface of the power supply body 3.

The power supply body 3 is formed from Ni, Al, Cu, an alloy containing any one of these metals, or the like. The power supply body 3 can have various shapes such as rod (pole), solid cylinder, cable, plate, woven string, and hollow cylinder-like shapes.

The high conductivity metal layer 5 is made of a material whose conductivity is higher than that of the power supply body 3 in an environment from room temperature to 900°C. For example, when the power supply body 3 is made of Ni, the high conductivity metal layer 5 is preferably formed from noble metal such as Au, Pt, or Rh.

Specifically, it is preferable that the volume resistivity of the high conductivity metal layer 5 at room temperature is not more than half of 6.8 µΩ·cm, which is the volume resistivity of Ni at room temperature. Moreover, it is preferable that the volume resistivity of the high conductivity metal layer 5 at 900°C is not more than half of 45.5 µΩ·cm, which is the volume resistivity of Ni at 900°C. The thickness of the high conductivity metal layer 5 is preferably 2 to 30 µm and more preferably 10 to 30 µm. This makes it possible to efficiently flow 80% or more of skin current through the high conductivity metal layer 5 when high frequency voltage at 10 MHz or more is applied to the power supply body 3. The high conductivity metal layer 5 is formed on the surface of the power supply body 3 (the outer peripheral surface) by means such as plating, thermal spraying, or brazing.

As described above, in the power supply member 1, the high conductivity metal layer 5 with a conductivity higher than that of the power supply body 3 is formed on the surface of the power supply body 3. This allows part of the skin current flowing through the surface part of the power supply body 3 to flow through the high conductivity metal layer 5 when high frequency voltage is applied to the power supply member 1. Accordingly, the resistance of the power supply body 3 when the high frequency voltage is applied thereto is reduced, and the amount of heat generated by the power supply body 3 can be reduced. Furthermore, the reduction in the amount of heat generated inhibits degradation of the power supply member 1, so that an increase in the resistance of the power supply member 1 itself can be reduced and arbitrary plasma power can be generated.

Next, a second power supply member for use in the plasma processing device of the present invention is described. The description is given of a power supply member including a high conductivity metal layer formed on the outer peripheral surface (on the surface side) of the power supply body with an diffusion preventing metal layer interposed therebetween.

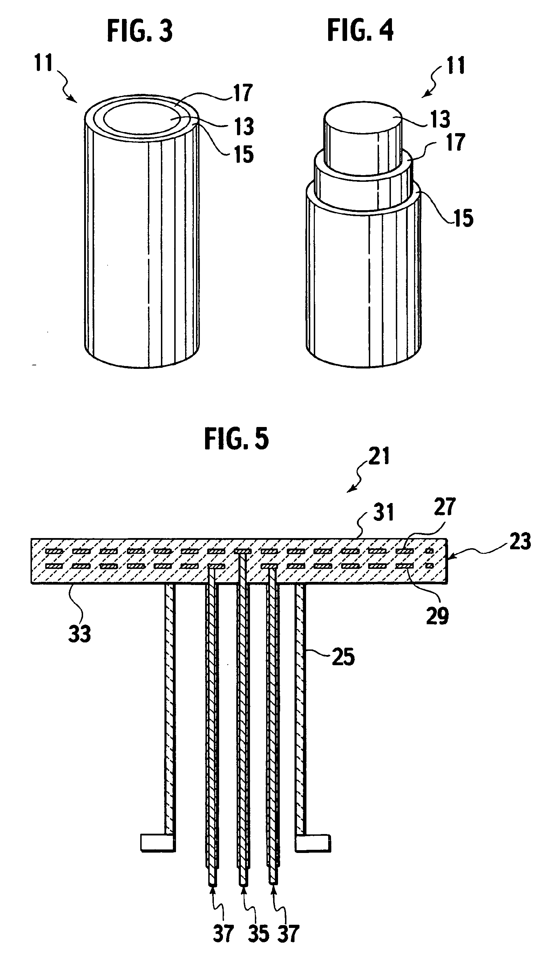

FIG. 3 is a perspective view of the second power supply member, and FIG. 4 is a perspective view showing the power supply member of FIG. 3 with upper part of the high conductivity metal layer and diffusion preventing metal layer omitted.

The power supply member 11 is formed into an elongated rod and includes a power supply body 13, a diffusion preventing metal layer 17, and a high conductivity metal layer 15. The power supply body 13 is arranged in the radial center of the power supply member 11. The diffusion preventing metal layer 17 is formed on the outer peripheral surface of the power supply body 13. The high conductivity metal layer 15 is formed on the outer peripheral surface of the diffusion preventing metal layer 17. The diffusion preventing metal layer 17 is formed between the power supply body 13 and high-conductivity metal layer 15.

The diffusion preventing metal layer 17 is made of metal at least Cr or Rh which hardly diffuses into the power supply body 13. Moreover, the thickness of the diffusion preventing metal layer 17 is preferably 0.1 to 5 µm. The diffusion preventing metal layer 17 is formed on the surface of the power supply body 13 by plating, thermal spraying, brazing, or the like. The conductivity of the diffusion preventing metal layer 17 may be lower than that of the power supply body 13. The high conductivity metal layer 15 is formed on the surface of the diffusion preventing metal layer 17 by plating, thermal spraying, brazing, or the like.

As described above, with the power supply body 11 of this embodiment, the diffusion preventing metal layer 17 is provided between the power supply body 13 and the high conductivity metal layer 15, which can prevent the high conductivity metal layer 15 from diffusing to the power supply body 13 in a high temperature environment. It is therefore possible to allow part of the skin current flowing through the surface part of the power supply body 13 to flow through the high conductivity metal layer 15 even in the high temperature environment and further reduce the amount of heat generated by the power supply body 13.

Next, a description is given of a substrate heater as a plasma processing device. The substrate heater includes the second power supply member according to the aforementioned example.

FIG. 5 is a perspective view showing the substrate heater.

This substrate heater 21 includes a ceramic base 23, which is formed into a disc, and a shaft 25, which is attached to a rear face 33 of the ceramic base 23 and supports the ceramic base 23. Within the ceramic base 23, a high frequency electrode 27 and a resistance heating element 29 are buried. This high frequency electrode 27 is disposed above the resistance heating element 29.

The upper surface of the ceramic base 23 is formed as a substrate placement surface 31 on which a substrate (wafer) is placed and held. The resistance heating element 29 is heated to heat the substrate on the substrate placement face 31. The ceramic base 23 is preferably formed fromAlN, SN, SiC, alumina, or the like.

The high frequency electrode 27 is supplied with high frequency current from later described power supply members 35 and 37 to generate plasma.

The high frequency electrode 27 can have various shapes such as mesh and plate-like shapes. The high frequency electrode 27 may be formed by printing conductive paste on the ceramic base 23. The high frequency electrode 27 is conductive and can be formed from a conductive high melting point material, for example, such as W, Mo, WMo, or WC.

The resistance heating element 29 can have various shapes such as mesh and coil-like shapes. The resistance heating element 29 may be formed by printing conductive paste on the ceramic base 23. The resistance heating element 29 is conductive and can be formed from a conductive high melting point material, for example, such as W, Mo, WMo, or WC.

The shaft 25 is formed into a hollow cylinder and can be made of ceramic, metal, or the like.

Within the shaft 25, the high frequency electrode power supply member 35 and resistance heating element power supply member 37 are provided.

The high frequency electrode power supply member 35 is joined to the high frequency electrode 27 by means such as calking, welding, brazing, or soldering. The resistance heating element power supply member 37 is joined to the resistance heating element 29 by means such as calking, welding, brazing, or soldering.

Each of these high frequency electrode power supply member 35 and resistance heating element power supply member 37 is the second power supply member 11 described above.

Specifically, the high frequency electrode power supply member 37 is the power supply member with the high conductivity metal layer 5 formed on the outer peripheral surface of the power supply body 3 with the diffusion preventing metal layer interposed therebetween (see FIGS. 3 and 4).

Furthermore, the resistance heating element power supply member 37 is the power supply member with the high conductivity metal layer 5 formed on the outer peripheral surface of the power supply body 3 with the diffusion preventing metal layer interposed therebetween (see FIGS. 3 and 4).

The present invention is defined by the claims. For example, in the substrate heater 21 as the plasma processing device, the resistance heating element 29 is buried in the ceramic base 23, and the shaft 25 is joined to the rear face 33 of the ceramic base 23. However, the resistance heating element 29 may be not provided, or the shaft 25 may be not provided.

### EXAMPLES

Next, the power supply member for the plasma processing device of the present invention is more specifically described through examples 1, 3, 4, 5 and 6.

### [Example 1]

As Example 1, the power supply member 11 shown in FIGS. 3 and 4 was produced.

Specifically, first, power supply bodies composed of Ni rods 200 mm long were prepared. Next, as the diffusion preventing metal layer, Rh was plated over the outer peripheral surface of each power supply body to a thickness of 0.5 µm. As the high conductivity metal layer, Au is plated over the outer peripheral surface of the diffusion preventing metal layer to a thickness of 20 µm, thus obtaining power supply members according to Example 1.

### [Example 2]

As Example 2, the power supply member 1 shown in FIGS. 1 and 2 was produced.

Specifically, first, power supply bodies composed of Ni rods 200 mm long were prepared. Next, Au is plated over the outer peripheral surface of each power supply body to a thickness of 20 µm without the formation of the diffusion preventing metal layer, thus obtaining power supply members according to Example 2.

### [Examples 3 to 6]

Power supply members according to Examples 3 to 6 were produced according to Table 1 below in a similar procedure to those of Examples 1 and 2.

**[Table 1]**

| | | Example 1 | Example 2 | Example 3 | Example 4 | Example 5 | Example 6 | Comparative Example 1 |
|---|---|---|---|---|---|---|---|---|
| High Conductivity Metal Layer | Material | Au | Au | Au | Au | Au | Au | Not formed |
| | Thickness [µm] | 20 | 20 | 2 | 10 | 30 | 20 | - |
| Diffusion Preventing Metal Layer | Material | Rh | Not formed | Rh | Rh | Rh | Cr | Not formed |
| | Thickness [µm] | 0.5 | - | 0.5 | 0.5 | 0.5 | 0.5 | - |
| Resistance (13.56 MHz) [mΩ] | | 78 | 66 | 332 | 183 | 71 | 85 | 796 |
| Peripheral Member Damage | | ○ | ○ | ○ | ○ | ○ | ○ | × |

### [Comparative Example 1]

As Comparative Example 1, a power supply member composed of a Ni rod 200 mm long was prepared. This power supply member was not provided with the diffusion preventing metal layer and high conductivity metal layer.

### [Evaluation 1 (Resistance at Room Temperature)]

The resistance of the power supply members of Examples 1 to 6 and Comparative Example 1 was measured when high frequency voltage at 13.56 MHz was applied thereto.

In Example 3, only by forming the high conductivity metal layer of Au with a thickness of 2 µm on the diffusion preventing metal layer, the resistance R thereof when high frequency voltage at 13.56 MHz was applied thereto could be reduced to half of that of Comparative Example 1, in which the high conductivity metal layer was not formed. Moreover, the equation (2) described in the above description of the related art revealed that the amount of heat generated by the power supply member of Example 3 when high frequency voltage was applied thereto could be reduced to half of that of Comparative Example 1 .

Moreover, Example 4 revealed that when the thickness of the high conductivity metal layer was set to 10 µm, the resistance R when high frequency voltage at 13.56 MHz was applied thereto could be reduced to 20% or less of that of Comparative Example 1. Examples 1, 2, 5, and 6 similarly revealed that when the thickness of the high conductivity metal layer was set to 20 µm or more, the resistance when the high frequency voltage at 13.56 MHz was applied thereto could be reduced to 10% or less of that of Comparative Example 1.

### [Evaluation 2 (Volume Resistivity of Power Supply Member Having been Held at 1000°C)]

Moreover, as shown in Table 2 below, after the power supply members were held in the atmosphere at 1000°C for 4 hours, resistance R thereof when high frequency voltage at 13.56 MHz was applied was measured in a similar way to that of Evaluation 1.

**[Table 2]**

| | Example 1 | Example 2 | Example 3 | Example 4 | Example 5 | Example 6 | Comparative Example 1 |
|---|---|---|---|---|---|---|---|
| Resistance (13.56 MHz) [mΩ] | 85 | 530 | 343 | 226 | 76 | 92 | 820 |
| Peripheral Member Damage | ○ | ○ | ○ | ○ | ○ | ○ | × |

As apparent from Table 2, holding the power supply member with the diffusion preventing metal layer not formed in the high temperature environment significantly increased the volume resistivity. This is thought to be because Au of the high conductivity metal layer diffused to the power supply body. It was therefore revealed that providing the diffusion preventing metal layer for the power supply member prevented Au of the high conductivity metal layer from diffusing to the power supply body and the resistance hardly varied even when the power supply member was held in the high temperature environment.

Examples 1 and 6 revealed that even when the material of the diffusion preventing metal layer was Cr, a similar effect to the case of Rh could be obtained.

### [Evaluation 3 (Damage Level of Peripheral Member)]

Furthermore, using the power supply members which had been and which had not been held at 1000°C, plasma processing devices were produced. Then, it was verified whether peripheral members were damaged when high frequency voltage of 2000 W at 13.56 MHz was applied to the power supply member. The results thereof are shown in Tables 1 and 2. Cases in which the peripheral members were damaged are indicated by x, and cases in which the peripheral members were damaged are indicated by o.

As shown in these Tables 1 and 2, in Comparative Example 1, the power supply members which had not been and which had been held in high temperature atmosphere at 1000°C both damaged the peripheral members when high frequency voltage was applied thereto.

As shown in Example 2, when the diffusion preventing metal layer was not provided, the power supply member which had not been held in high temperature atmosphere at 1000°C did not damage the peripheral members when high frequency voltage was applied, but the power supply member which had been held in the high temperature atmosphere at 1000°C damaged the peripheral members.

This revealed that providing the diffusion preventing metal layer was preferable.

## Claims

1. A plasma processing device, comprising a base(23) including an electrode(27) to which high frequency voltage is applied, and a power supply member (11, 35) arranged to supply high frequency current to the electrode, the power supply member (11,35) including:
a power supply body (13) ;
a high conductivity metal layer (15) having a conductivity higher than that of the power supply body, the high conductivity metal layer being provided on a surface side of the power supply body and being formed of gold (Au);
and a diffusion preventing metal layer(17) between the power supply body and the high conductivity metal layer for preventing the high conductivity metal layer (15) from diffusing to the power supply body (13) , the diffusion preventing metal layer(17) being formed from at least one of Cr and Rh,
**characterized in that** the power supply body (13) is formed as a rod of nickel (Ni) and **in that** the high conductivity metal layer has a thickness of from 2 to 30 µm.

2. The plasma processing device according to claim 1, wherein the base(23) includes a resistance heating element(29), the plasma processing device further comprising a power supply member(37) which supplies current to the resistance heating element.

## Patentansprüche

1. Plasmaverarbeitungsvorrichtung, die Folgendes umfasst: eine Basis (23), die eine Elektrode (27) umfasst, an die eine Hochfrequenzspannung angelegt wird, und ein Stromversorgungselement (11, 35), um die Elektrode mit Hochfrequenzstrom zu versorgen, wobei das Stromversorgungselement (11, 35) Folgendes umfasst:
einen Stromversorgungskörper (13);
eine hochleitfähige Metallschicht (15) mit einer höheren Leitfähigkeit als der Stromversorgungskörper, wobei die hochleitfähige Metallschicht auf einer Oberfläche des Stromversorgungskörpers bereitgestellt ist und aus Gold (Au) besteht;
sowie eine diffusionsverhindernde Metallschicht (17) zwischen dem Stromversorgungskörper und der hochleitfähigen Metallschicht, um zu verhindern dass die hochleitfähige Metallschicht (15) in den Stromversorgungskörper (13) diffundiert, wobei die diffusionsverhindernde Metallschicht (17) aus zumindest einem aus Cr und Rh ausgewählten Element besteht,
**dadurch gekennzeichnet, dass** der Stromversorgungskörper (13) aus einem Stab aus Nickel (Ni) besteht und dass die hochleitfähige Metallschicht eine Dicke von 2 bis 30 µm aufweist.

2. Plasmaverarbeitungsvorrichtung nach Anspruch 1, worin die Basis (23) ein Widerstandsheizelement (29) umfasst, wobei die Plasmaverarbeitungsvorrichtung ferner ein Stromversorgungselement (37) umfasst, das das Widerstandsheizelement mit Strom versorgt.

## Revendications

1. Dispositif de traitement au plasma, comprenant une base (23) incluant une électrode (27) à laquelle une tension haute fréquence est appliquée, et un élément d'alimentation électrique (11, 35) conçu pour fournir un courant haute fréquence à l'électrode, l'élément d'alimentation électrique (11, 35) incluant :
un corps d'alimentation électrique (13) ;
une couche de métal à haute conductivité (15) ayant une conductivité supérieure à celle du corps d'alimentation électrique, la couche de métal à haute conductivité étant prévue sur un côté de surface du corps d'alimentation électrique et constituée d'or (Au) ;
et une couche de métal empêchant la diffusion (17) entre le corps d'alimentation électrique et la couche de métal à haute conductivité pour empêcher la diffusion de la couche de métal à haute conductivité (15) au corps d'alimentation électrique (13), la couche de métal empêchant la diffusion (17) étant formée d'au moins l'un du Cr et du Rh,
**caractérisé en ce que** le corps d'alimentation électrique (13) a la forme d'une tige de nickel (Ni) et **en ce que** la couche de métal à haute conductivité a une épaisseur de 2 à 30 µm.

2. Dispositif de traitement au plasma selon la revendication 1, dans lequel la base (23) comprend un élément de chauffage par résistance (29), le dispositif de traitement au plasma comprenant en outre un élément d'alimentation électrique (37) qui fournit du courant à l'élément de chauffage par résistance.
